(19) Europäisches Patentamt
European Patent Office
Office européen des brevets

(11) Veröffentlichungsnummer: **0 005 778**
**B1**

(12) **EUROPÄISCHE PATENTSCHRIFT**

(45) Veröffentlichungstag der Patentschrift: **18.05.83**

(51) Int. Cl.³: **G 03 F 7/08**

(21) Anmeldenummer: **79101535.7**

(22) Anmeldetag: **21.05.79**

(54) **Verfahren zur Herstellung von Reliefaufzeichnungen.**

(30) Priorität: **26.05.78 DE 2822887**

(43) Veröffentlichungstag der Anmeldung:
**12.12.79 Patentblatt 79/25**

(45) Bekanntmachung des Hinweises auf die Patenterteilung:
**18.05.83 Patentblatt 83/20**

(84) Benannte Vertragsstaaten:
**AT BE CH DE FR GB IT NL SE**

(56) Entgegenhaltungen:
**DE - A - 1 447 952**
**DE - A - 1 522 503**
**DE - A - 2 024 242**
**DE - A - 2 024 243**
**DE - A - 2 024 244**
**DE - A - 2 637 768**
**DE - A - 2 728 947**
**US - A - 3 867 147**

**Die Akte enthält technische Angaben, die nach dem Eingang der Anmeldung eingereicht wurden und die nicht in dieser Patentschrift enthalten sind.**

(73) Patentinhaber: **HOECHST AKTIENGESELLSCHAFT**
**Postfach 80 03 20**
**D-6230 Frankfurt/Main 80 (DE)**

(72) Erfinder: **Uhlig, Fritz, Dr. Dipl-Chem.**
**Weinfeldstrasse 1**
**D-6200 Wiesbaden (DE)**

**EP 0 005 778 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Verfahren zur Herstellung von Reliefaufzeichnungen

Die Erfindung betrifft ein Verfahren zur Herstellung von Reliefaufzeichnungen, bei dem man ein lichtempfindliches Aufzeichnungsmaterial, das in der lichtempfindlichen Schicht ein Diazoniumsalz-Polykondensationsprodukt und ein Aminharz enthält, mit inkohärentem aktinischem Licht belichtet und entwickelt.

Aus der DE—C—14 47 952 ist eine vorsensibilisierte Druckplatte bekannt, die in der lichtempfindlichen Schicht ein Kondensationsprodukt aus Diazoniumsalz und Formaldehyd sowie ein Aminharz enthält. Die Lichtempfindlichkeit dieses Materials ist nicht besonders hoch. Aus der Patentschrift ist nicht ersichtlich, daß sie durch das Aminharz beeinflußt wird.

Aus der DE—A—20 24 244 (=US—A—3 867 147) sind ähnliche Aufzeichnungsmaterialien bekannt, die als lichtempfindliche Substanzen Polykondensationsprodukte aus kondensationsfähigen Diazoniumsalzen und kondensationsfähigen, nicht lichtempfindlichen Zweitkomponenten enthalten. Diese Kondensationsprodukte verleihen dem Material eine höhere Lichtempfindlichkeit. Sie können in der lichtempfindlichen Schicht noch weitere Bestandteile, wie Aminharze und Farbstoffe, z. B. Triphenylmethanfarbstoffe enthalten. Die Lichtempfindlichkeit des Materials wird, soweit es aus der Offenlegungsschrift hervorgeht, durch derartige Zusätze, deren Menge normalerweise kleiner ist als die der Diazoniumsalz-Polykondensationsprodukte, nicht beeinflußt.

In der älteren deutschen Patentanmeldung P 27 28 947 wird ein Verfahren zur Herstellung von Flachdruckformen vorgeschlagen, bei dem eine Druckplatte mit einem Schichtträger aus anodisiertem Aluminium, dessen Oxidschicht mindestens 3 $g/m^3$ wiegt, und einer lichtempfindlichen Schicht aus einer negativ arbeitenden Diazoverbindung, z. B. einem Diazoniumsalz-Polykondensationsprodukt, und einem Aminharz mit bildmäßig gesteuerten Laserstrahlen bestrahlt wird. Das Aminharz, das in einer Menge von 0,1 bis 10 Gewichtsteilen je 1 Gewichtsteil Diazoverbindung zugesetzt wird, hat die Wirkung, die Empfindlichkeit gegenüber Laserstrahlen und die Druckauflage der Druckform zu erhöhen.

Aufgabe der Erfindung war es, ein Verfahren zur Herstellung von Reliefaufzeichnungen durch Belichtung eines negativ arbeitenden lichtempfindlichen Aufzeichnungsmaterials auf Basis lichtempfindlicher Diazoverbindungen mit inkohärentem Licht vorzuschlagen, das eine besonders kurze Belichtung ermöglicht.

Die Erfindung geht aus von einem Verfahren zur Herstellung von Reliefaufzeichnungen, bei dem man ein Aufzeichnungsmaterial, das in der lichtempfindlichen Schicht ein Aminharz und ein Diazoniumsalz-Polykondensationsprodukt aus wiederkehrenden Einheiten der allgemeinen Typen

$$[\bar{A}—N_2X] \text{ und } [B]$$

enthält, die miteinander durch zweibindige, von einer kondensationsfähigen Carbonylverbindung abgeleitete Zwischenglieder verbunden sind, worin

A der Rest eines Diazoniumsalzes ist, das mindestens zwei iso- oder heterocyclische aromatische Ringe enthält und das in saurem Medium an mindestens einer Stelle des Moleküls mit Formaldehyd zu kondensieren vermag,

B der Rest einer von Diazoniumgruppen freien Verbindung, die in saurem Medium an mindestens einer Stelle des Moleküls mit Formaldehyd zu kondensieren vermag, und

X das Anion des Diazoniumsalzes ist,

mit inkohärentem aktinischem Licht hinter einer Vorlage belichtet und die unbelichteten Bereiche der lichtempfindlichen Schicht mit einem Entwickler auswäscht.

Das erfindungsgemäße Verfahren ist dadurch gekennzeichnet, daß man ein Aufzeichnungsmaterial verwendet, dessen lichtempfindliche Schicht 6 bis 20, bevorzugt 7 bis 15 Gewichtsteile Aminharz je 1 Gewichtsteil Diazoniumsalz-Polykondensationsprodukt enthält.

Die verwendeten Diazoniumsalz-Polykondensationsprodukte sind bekannt und z. B. in der DE—A—20 24 244 oder der US—A—3 867 147 eingehend beschrieben. Von diesen Kondensationsprodukten werden diejenigen bevorzugt, bei denen die Einheiten B durch Kondensation entstandene Reste von aromatischen Aminen,

Phenolen, Thiophenolen, Phenoläthern, aromatischen Thioäthern, aromatischen Kohlenwasserstoffen, aromatischen heterocyclischen Verbindungen oder organischen Säureamiden sind.

Die Einheiten A—$N_2$X leiten sich bevorzugt von Verbindungen der Formel

$$(R_1—R_3—)_pR_2—N_2X$$

ab, worin

X des Anion des Diazoniumsalzes,

p eine ganze Zahl von 1 bis 3,

$R_1$ einen aromatischen Rest mit mindestens einer kondensationsfähigen Position,

$R_2$ eine unsubstituierte oder durch Halogenatome, Carboxyl-, Sulfonyl-, Alkyl- oder Alkoxy-gruppen substituierte Phenylengruppe,

$R_3$ eine Einfachbindung oder eine der Gruppen:

$$—(CH_2)_q—NR_4—$$

$$—O—(CH_2)_r—NR_4—$$

$$—S—(CH_2)_r—NR_4—$$

$$—S—CH_2CO—NR_4—$$

$$—O—R_5—O—$$

$$—O—$$

$$—S— \text{ oder}$$

$$—CO—NR_4—$$

bedeutet, worin

q eine Zahl von 0 bis 5,

r eine Zahl von 2 bis 5,

$R_4$ Wasserstoff, eine Alkylgruppe mit 1—5 C-Atomen, eine Aralkylgruppe mit 7—12 C-Atomen oder eine Arylgruppe mit 6—12 C-Atomen, und

$R_5$ eine Arylengruppe mit 6—12 C-Atomen ist.

Durch den Zusatz von Aminharzen in den angegebenen Mengen zu der lichtempfindlichen Schicht wird eine Erhöhung der Lichtempfindlichkeit auf ein Mehrfaches der entsprechenden aminharzfreien Schicht erreicht. Dieses Ergebnis ist besonders überraschend, da bei dem Zusatz von Aminharzen zu Aufzeichnungsschichten aus Diazoniumsalz-Formaldehyd-Kondensationsprodukten (DE—C—14 47 952) keine wesentliche Steigerung der Lichtempfindlichkeit beobachtet wurde. Auch die in der alteren Anmeldung P 25 28 947 beschriebene Steigerung der Empfindlichkeit für Laserstrahlung durch Aminharzzusatz, die dort außerdem an die Verwendung von Aluminiumträgern mit anodischen Oxidschichten bestimmter Dicke geknüpft ist, erreicht bei weitem nicht das durch die Erfindung erzielte Ausmaß.

Die Lichtempfindlichkeit der Aufzeichnungsschichten wird durch Zusatz von Farbstoffen in den unten angegebenen Mengen noch weiter erhöht, so daß durch die Kombination beider Zusätze eine optimale Wirkung erreicht wird.

Als Lichtquellen für die bildmäßige Belichtung der Schichten sind die in der Reproduktionstechnik üblichen Metallhalogenidlampen mit bis zu mehreren Kilowatt Leistungsaufnahme bevorzugt geeignet. Mit ihnen werden bei Schichtdicken in der Größenordnung von 1 $\mu$m, wie sie für Flachdruckplatten üblich sind, Belichtungszeiten von wenigen Sekunden erzielt. Es können aber auch die bekannten Xenonlampen und Kohlenbogenlampen, pneumatische Flachbelichter mit Leuchtstoffröhren sowie Projektionsbelichtungsgeräte verwendet werden, die ausreichend intensive Anteile im nahen ultravioletten und/oder kurzwelligen sichtbaren Spektralbereich emittieren.

Als Aminharze werden vorzugsweise Amin-Formaldehyd-Kondensationsharze eingesetzt, die durch Kondensation von Formaldehyd mit Harnstoff, Urethanen (Carbamidsäureestern), Anilin oder Melamin entstehen. Derartige Kondensationsprodukte sind bekannt und in vielen Ausführungen als Handelsprodukte erhältlich. Geeignete Vertreter sind z. B. beschrieben im Kunststoff-Handbuch, Band X, herausgegeben von Vieweg und Becker im Carl Hanser Verlag München (1968).

Es kann vorteilhaft sein, den Schichten Farbstoffe bzw. Pigmente zuzusetzen, z. B. Triphenylmethanfarbstoffe, Azofarbstoffe oder Pigmentfarbstoffe wie Phthalocyanine in Form von Dispersionen. Vorzugsweise wählt man das Gewichtsverhältnis von Diazopolykondensat zu Farbstoff zwischen 1:0,5 und 1:4.

Beispiele für gut geeignete Triphenylmethanfarbstoffe sind Kristallviolett (C.I. 42555), Astrazonorange, Brillantblausalz SM (C.I. Solvent Blue 66), Patentblau AE, Rhodamine, Viktoriareinblau B conz. (C.I. 42525), Viktoriareinblau FGA (C.I. Basic Blue 81), Patentblau V (C.I. 42045), Eosin, Malachitgrün (C.I. 42000), Brillantgrün, Rosanilin, Methylviolett (C.I. 42535), Wasserblau, Spritblau, Phenolphthalein und Acetosolgrün.

Das Aufzeichnungsmaterial kann bereits als vorsensibilisiertes Material hergestellt und gelagert oder es kann das Beschichtungsgemisch in Form einer Lösung oder Dispersion aufbewahrt und transportiert und vom Verbraucher selbst auf einen individuellen Träger, z. B. für die Herstellung von Ätzschutzschichten, aufgebracht und nach dem Trocknen belichtet und entwickelt werden. Es ist auch möglich, daß fabrikatorisch präpariertes Trägermaterial erst durch den Verbraucher im Selbstbeschichtungs-("Wipe-On")-Verfahren mit der Lösung beschichtet wird, oder daß fabrikatorisch das Aminharz

auf einen Träger aufgebracht wird und der Verbraucher im "Wipe-On"-Verfahren mit dem Diazoniumsalz-Polykondensat sensibilisiert, wobei gegebenenfalls ein Farbstoff entweder mit dem Harz oder mit dem Diazoniumsalz-Polykondensat oder mit beiden zusammen aufgetragen wird.

Vorzugsweise wird das Aufzeichnungsmaterial in Form eines vorsensibilisierten Materials für die photomechanische Herstellung von Druckplatten, besonders von Flachdruckplatten, in den Handel gebracht. Als Lösungsmittel für die fabrikatorische Herstellung kommen als gute Löser bekannte Flüssigkeiten in Frage wie Alkohole, Amide und Ketone; bevorzugt sind Äthylenglykolmonomethyläther, Äthylenglykolmonoäthyläther, Äthylenglykolmonoisopropyläther, Dimethylformamid, Diacetonalkohol und Butyrolacton. Zur Erzielung gleichmäßiger Schichten werden diesen Lösungsmitteln oftmals noch Äther und Ester wie Dioxan, Tetrahydrofuran, Butylacetat und Äthylenglykolmethylätheracetat zugesetzt. Das lichtempfindliche Gemisch wird, in einem oder mehreren der genannten Lösungsmittel gelöst, auf einen für die Reprographie geeigneten Schichtträger aufgebracht und die aufgetragene Lösung getrocknet. Die Beschichtung kann durch Aufschleudern, Sprühen, Tauchen, Antragen mittels Walzen oder mit Hilfe eines Flüssigkeitsfilms erfolgen.

Als Schichtträger sind die verschiedensten Materialien wie Papier, Zink, Magnesium, Aluminium, Chrom, Kupfer, Messing, Stahl und Mehrmetall- oder Kunststoffolien geeignet. Für die Herstellung von Flachdruckplatten wird vorzugsweise mechanisch, chemisch oder mit Hilfe des elektrischen Stroms aufgerauhtes und/oder anodisiertes Aluminium verwendet, das vorteilhaft vor der Sensibilisierung mit Phosphonsäuren oder Derivaten von Phosphonsäuren gemäß den DE—C—1 160 733 oder 16 21 478, mit Alkalisilikat gemäß DE—C—907 147, mit Zirkon- oder Titanhexahalogeniden gemäß den DE—B—1 183 919 und 1 192 666, mit monomeren und polymeren Carbonsäuren oder mit einer Benzophenonverbindung nach der DE—B—16 71 643 vorbehandelt worden ist.

Außer den vorstehend beschriebenen Schichtkomponenten können den Kopierschichten nach verschiedene andere Harze in kleinerer Menge, d. h. bis zu etwa 20 Gew.-% der gesamten Harzmenge, zugesetzt werden, z. B. Phenolharze, unmodifizierte Epoxidharze auch höheren Molekulargewichts, ölmodifizierte Alkydharze, Polyamide, Polyurethane, Polyvinylharze, Acrylharze, Polyvinylacetate, Polyvinylchlorid, Polyester, Nitrocellulose, Polyvinylacetale usw.

Den Kopierschichten können zusätzlich Weichmacher, Netzmittel und Indikatoren zugesetzt werden. Alle Zusätze sollen so ausgewählt sein, daß sie mit den anderen Schichtbestandteilen verträglich sind und außerdem im Absorptionsbereich der lichtempfindlichen Substanz möglichst wenig absorbieren.

Vorsensibilisierte Flachdruckplatten, die nur dünne Schichten ab etwa 0,1 $g/m^2$ nach dem erfindungsgemäßen Verfahren tragen, besitzen bereits hervorragende kopier- und drucktechnische Eigenschaften, wie besonders hohe Lichtempfindlichkeit, gute Entwickelbarkeit bei guter Entwicklerresistenz, ausgezeichnete Lagerfähigkeit und hohe Druckauflage bei tonwertrichtiger Bildwiedergabe. Im allgemeinen werden Schichtdicken von etwa 0,3 bis 1,5 $g/m^2$ bevorzugt.

Die Verarbeitung der Aufzeichnungsmaterialien, insbesondere der vorsensibilisierten Druckplatten bis zur druckbereiten Form geschieht in üblicher Weise. Es wird hinter einer Vorlage mit Lichtquellen belichtet, die im UV-Bereich des Spektrums liegende Strahlen aussenden. Während die Schicht an den Stellen, auf die das Licht einwirkt, gehärtet und unlöslich wird, werden die unbelichteten, löslich bleibenden Teile der Schicht durch Tauchen und/oder Tamponieren mit der Hand oder in einem Gerät mit einem geeigneten Entwickler entfernt. Die so hergestellte Flachdruckform wird nach der Entwicklung ggf. mit fetter Farbe eingefärbt und mit einem Konservierungsmittel wie Gummierabicum versehen.

Als Entwickler werden wäßrige, schwach alkalische Lösungen bevorzugt, die bis zu 15% ihres Volumens organische Lösungsmittel, z. B. niedere, ein- oder mehrwertige aliphatische Alkohole, wie Äthanol, Propanole, Glycerin, Glykole, Benzylalkohol und ähnliche enthalten können. Die Lösungen enthalten im allgemeinen ferner Netzmittel und Salze.

Die lichtempfindlichen Aufzeichnungsmaterialien werden vor allem für die Herstellung von Flachdruckplatten verwendet. Sie können auch nach dem Entwickeln durch Ätzen in Hoch- oder Tiefdruckformen oder in Mehrmetalldruckformen übergeführt werden. Ebenso können sie zur Herstellung kopierter Schaltungen, von Siebdruckformen und dgl. verwendet werden. Es können auch Aufzeichnungsschichten hoher photographischer Dichte, besonders im aktinischen Spektralbereich, auf transparente Träger, vorzugsweise Polyesterfolien, aufgebracht und zu Farbbildern verarbeitet werden, die als Kopiervorlagen, z. B. als Ersatz für lithographische Silberfilme, verwendet werden können.

Die folgenden Beispiele erläutern bevorzugte Ausführungsformen des erfindungsgemäßen Verfahrens. Prozentangaben sind, wenn nichts anderes angegeben ist, Gewichtsprozente. Als Gewichtsteil (Gt.) ist 1 g zu setzen, wenn als Volumenteil (Vt.) 1 ccm gewählt wird.

Beispiel 1

Eine Aluminiumplatte von 0,3 mm Dicke wird durch Bürsten mechanisch aufgerauht und 30 Sekunden in ein 60°C warmes Bad von 0,3 Gew.-% Polyvinylphosphonsäure in Wasser getaucht und getrocknet. Danach wird die derart vorbehandelte Aluminiumplatte mit einer lösung der folgenden Zusammensetzung beschichtet:

1,2 Gt. des unten beschriebenen Diazoniumsalz-Polykondensats,
0,2 Gt. 85 %ige Phosphorsäure,
4,33 Gt. eines hochreaktiven, nichtplastifizierten Harnstoff-Formaldehydharzes in 60 %iger Isobutanollösung, dynamische Viskosität der Lösung ungefähr 2500 mPa·s (cP) bei 20°C, Säurezahl unter 2,
0,52 Gt. eines nichttrocknenden Alkydharzes in 60 %iger, Xylollösung, dynamische Viskosität der Lösung 500—650 mPa·s bei 20°C, Säurezahl unter 10,
0,30 Gt. Methylviolett (C.I. 42 535),
60,0 Gt. Äthylenglykolmonomethyläther,
20,0 Gt. Tetrahydrofuran,
10,0 Gt. Dimethylformamid,
10,0 Gt. Butylacetat.

Die mit der obigen Lösung sensibilisierte Aluminiumplatte wird getrocknet und zur Herstellung der Druckform 6 Sekunden unter einem photographischen Negativ mit einer 5 kW Xenonlampe eines Kopiergerätes belichtet. Die belichtete Schicht wird mit einer Lösung aus

0,15 Gt. Natriummetasilikat · 9 Wasser,
0,50 Gt. Natriumdodecylhydrogensulfat,
1,00 Gt. Benzylalkohol,
98,35 Gt. Wasser

entwickelt und eingefärbt. Die Platte ist dann druckfertig.

Das Diazopolykondensat wird hergestellt durch Kondensieren von 1 Mol 3-Methoxy-diphenylamin-4-diazoniumsulfat mit 1 Mol 4,4′-Bis-methoxymethyl-diphenyläther in 85 %iger Phosphorsäure bei 40°C. Das Kondensat wird als Mesitylensulfonat isoliert.

Beispiel 2

Ein naßfestes Papier von 120 g/m² wird beidseitig mit einer Schicht von je 29 g/m² beschichtet, die aus 100 Gewichtsteilen Ton und 20 Gewichtsteilen Casein besteht, und dann kalandriert. Dann wird auf eine Seite eine wäßrige Lösung von 1% Natriumalginat und 0,6% Ammoniumbichromat in solcher Menge aufgebracht daß ein Trockenschichtgewicht von 2,5 g/m² erhalten wird. Die Platte wird dann mit 2 %iger wäßriger Kieselsäuredispersion gewaschen und getrocknet.

Man beschichtet die erhaltene Papierdruckfolie mit folgender Lösung:

0,20 Gt. des in Beispiel 1 beschriebenen Diazoniumsalz-Polykondensats,
0,02 Gt. 85 %ige Phosphorsäure,
2,60 Gt. eines nichtplastifizierten relativ hochviskosen Harnstoffharzes in 65 %iger Butanollösung, dynamische Viskosität der Lösung ungefähr 3650 mPa·s bei 25°C, Säurezahl unter 3,
0,2 Gt. Viktoriareinblau BOC (C.I. 42 595),
97,0 Gt. Äthylenglykolmonomethyläther.

Zur Herstellung der Druckform wird nach einer Belichtung von 3 Sekunden durch Oberwischen mit dem in Beispiel 1 angegebenen Entwickler entwickelt.

Beispiel 3

Eine Aluminiumplatte wird durch Bürsten mechanisch aufgerauht und 1 Minute bei 70°C in 20 %ige Trinatriumphosphat-Lösung getaucht, mit Wasser gespült und nach nochmaligem Spülen mit warmem Wasser 3 Minuten in 2 %iger Natriumsilikatlösung bei 90°C vorbehandelt, danach kurz mit Wasser gespült und getrocknet.

Diese vorbehandelte Platte wird mit der folgenden Lösung beschichtet:

6,0 Gt. eines säurehärtbaren, nichtplastifizierten Harnstoffharzes in 63 %iger Äthanollösung, dynamische Viskosität der Lösung ungefähr 525—700 mPa·s bei 20°C, Säurezahl unter 2,
0,6 Gt. Brillantblausalz SM (C.I. Solvent Blue 66)

und getrocknet.

Die Platte wird dann vor der Verwendung mit einer 0,6 %igen wäßrigen Lösung eines Diazoniumsalz-Polykondensates, wie in Beispiel 1 beschrieben, jedoch als Methansulfonat abgeschieden, in einem Walzenantraggerät ("Roller-Coater") sensibilisiert und getrocknet. Nach 6 Sekunden Belichtung hinter einer Filmvorlage wird in einem Arbeitsgang mit einer Lackemulsion folgender Zusammensetzung entwickelt und lackiert:

Nichtwäßrige Phase:

30 Gt. Äthylenglykolmethylätheracetat,
40 Gt. Cyclohexanon,

25 Gt. Xylol,
25 Gt. Tetrahydronaphthalin,
50 Gt. Kresol-Formaldehyd-Novolak, Schmelzbereich 108—118°C,
5 Gt. Litholrubin B

Wäßrige Phase:

36 Gt. Gummi arabicum,
340 Gt. Wasser,
2 Gt. Netzmittel (Fettsäurekondensationsprodukt mit Hydroxyäthylsulfonsäure)

Beispiel 4

Eine durch Nylonbürsten in einer Bimskiessuspension aufgerauhte Aluminiumrolle wird während 30 Sekunden in eine einprozentige Kalium-hexafluorozirkonat-Lösung von 70°C getaucht, mit Wasser gewaschen und getrocknet. Man sensibilisiert mit folgender Lösung:

0,40 Gt. eines Diazoniumsalz-Polykondensats, hergestellt aus 1 Mol 3-Methoxy-diphenylamin-4-diazoniumsulfat und 0,5 Mol Bis-methoxymethyl-diphenyläther in 86 %iger Phosphorsäure bei 40°C, ausgefällt als Naphthalin-2-sulfonat,
0,08 Gt. 85 %ige Phosphorsäure,
8,20 Gt. eines nicht plastifizierten Melaminharzes in 50 %iger alkoholischer Lösung, dynamische Viskosität der Lösung 300—600 mPa·s bei 20°C Säurezahl unter 1,
0,82 Gt. eines Epoxidharzes aus Bisphenol A und Epichlorhydrin mit dem Schmelzpunkt um 70°C, dem Epoxid-Äquivalentgewicht 459, einem Hydroxylwert um 0,3 und einem Molgewicht unterhalb 1000,
0,30 Gt. Kristallviolettbase (C.I. 42555)

Zur Herstellung der Druckform belichtet man 5 Sekunden unter einer 5 kW MH-Lampe und entwickelt mit einer Lösung aus

0,3 Gt. Natriummetasilikat · 9 Wasser,
2,0 Gt. Natriumlaurylsulfat,
4,0 Gt. Benzylalkohol,
93,5 Gt. Wasser.

Beispiel 5

Ein mit einer anodischen Oxidschicht von 2,5 $g/m^2$ versehenes und mit Polyvinylphosphonsäure vorbehandeltes Al-Band wird mit folgender Lösung sensibilisiert:

0,40 Gt. des in Beispiel 1 beschriebenen Diazoniumsalz-Polykondensats,
0,04 Gt. 85 %ige Phosphorsäure,
4,80 Gt. eines nichtplastifizierten, mittelviskosen Harnstoffharzes in 65 %iger Butanollösung, dynamische Viskosität der Lieferform 3000—3600 mPa·s bei 20°C, Säurezahl unter 2,
0,40 Gt. Viktoriareinblau FGA (C.I. Basic Blue 81),
76,0 Gt. Äthylenglykolmonomethyläther,
17,0 Gt. Tetrahydrofuran,
4,4 Gt. Butylacetat.

Die mit der obigen Lösung sensibilisierte Al-Rolle wird auf Formate geschnitten. Zur Herstellung einer Druckform belichtet man 3 Sekunden hinter einer Vorlage mit einer 5 kW Metallhalogenidlampe und entwickelt mit einer Lösung folgender Zusammensetzung:

0,2 Gt. Natriummetasilikat · 9 Wasser,
0,5 Gt. Natriumsulfat · 10 Wasser,
0,8 Gt. eines anionaktiven Netzmittels, Ammoniumalkylpolyoxyäthylensulfat (Alkylgruppe mit etwa 18 C-Atomen),
2,0 Gt. Benzylalkohol,
96,5 Gt. Wasser.

Ähnlich gute Ergebnisse erhält man, wenn der Lösung noch

0,48 Gt. eines aminharzvernetzenden Acrylharzes mit der dynamischen Viskosität 340—650 mPa·s bei 20°C und der Säurezahl entsprechend DIN 53183 von 60—90

oder die gleiche Menge (0,48 Gt.) eines nichtplastifizierten, hochreacktiven Melaminharzes in 55 %iger

Isobutanollösung, dynamische Viskosität der Lieferform 380—500 cP bei 20°C, Säurezahl unter 1 zugesetzt wird.

Beispiel 6

Ein wie im Beispiel 5 vorbehandeltes Al-Band mit einer anodischen Oxidschicht von 1 g/m² wird mit folgender Lösung sensibilisiert:

0,4 Gt. des in Beispiel 4 beschriebenen Diazoniumsalz-Polykondensats,
0,1 Gt. 85 %ige Phosphorsäure,
6,0 Gt. eines Harnstoffharzes in 65 %iger Isobutanollösung, dynamische Viskosität der Lieferform 1800—2100 mPa·s, Säurezahl unter 3,
1,0 Gt. eines nichttrocknenden, modifizierten Alkydharzes auf Basis verzweigter Fettsäuren in 60 %iger Xylollösung, Viskosität der Lieferform 2,5—4,5 mPa·s, Säurezahl 5—10,
1,6 Gt. Patentblau V (C.I. 42045).

Das Band wird zu Druckplatten zerschnitten,

Zur Herstellung einer Druckform wird die Druckplatte in einem Mikrofilm-Rückvergrößerungsgerät, das mit einer 1 kW Hg-Hochdrucklampe und entsprechendem Objektiv auf 6-fache lineare Vergrößerung eingestellt ist, 8 Sekunden belichtet und mit folgender Lösung entwickelt:

0,3 Gt. Natriummetasilikat · 9 Wasser,
0,1 Gt. Trinatriumphosphat,
2,0 Gt. Na-laurylsulfat,
4,0 Gt. Benzylakohol,
93,5 Gt. Wasser.

Beispiel 7

Ein nach Beispiel 5 vorbehandeltes Al-Band mit einer anodischen Oxidschicht von 3,2 g/m² wird mit folgender Lösung sensibilisiert:

0,20 Gt. des in Beispiel 1 beschriebenen Diazoniumsalz-Polykondensats.
0,04 Gt. 85 %ige Phosphorsäure,
4,00 Gt. eines nichtplastifizierten, relativ niedrigviskosen, hochreaktiven Harnstoffharzes in 60 %iger Isobutanollösung, dynamische Viskosität der Lieferform 500—800 mPa·s, Säurezahl unter 3.

Das Band wird in Formate zerschnitten.

Zur Herstellung einer Druckform wird die Druckplatte unter einer 5 kW MH-Lampe 2 Sekunden belichtet und mit folgender Lösung entwickelt:

0,5 Gt. Natriumsalz von Diisobutylnaphthalinsulfonsäure,
1,5 Gt. Benzylalkohol,
98,0 Gt. entionisiertes Wasser.

Beispiel 8

Ein nach den Angaben von Beispiel 5 hergestelltes Aluminiumband wird mit folgender Lösung beschichtet:

0,40 Gt. des in Beispiel 1 angegebenen Diazoniumsalz-Polykondensats,
0,04 Gt. 85 %ige Phosphorsäure,
6,00 Gt. des in Beispiel 5 verwendeten Harnstoffharzes,
4,00 Gt. einer Dispersion, dei 10 Gt. eines blauen Phthalocyaninpigments (C.I. 74 160) und 10 Gt. Polyvinylacetal in 80 Gt. Äthylenglykolmethylätheracetat enthält,
90,00 Gt. Äthylenglykolmonomethyläther.

Zur Herstellung der Druckform wird 3 Sekunden unter einer MH-Lampe belichtet und mit einer Lösung von

0,2 Gt. Natriummetasilikat · 9 Wasser,
0,5 Gt. Natriumsulfat · 10 Wasser,
0,2 Gt. des in Beispiel 5 angegebenen Netzmittels,
10,0 Gt. n-Propanol
89,1 Gt. Wasser

entwickelt.

**Patentansprüche**

1. Verfahren zur Herstellung von Reliefaufzeichnungen, bei dem man ein Aufzeichnungsmaterial, das in der lichtempfindlichen Schicht ein Aminharz und ein Diazoniumsalz-Polykondensationsprodukt aus wiederkehrenden Einheiten der allgemeinen Typen

$$[A—N_2X] \text{ und } [B]$$

enthält, die miteinander durch zweibindige, von einer kondensationsfähigen Carbonylverbindung abgeleitete Zwischenglieder verbunden sind, worin

A der Rest eines Diazoniumsalzes ist, das mindestens zwei iso- oder heterocyclische aromatische Ringe enthält und das in saurem Medium an mindestens einer Stelle des Moleküls mit Formaldehyd zu kondensieren vermag,
B der Rest einer von Diazoniumgruppen freien Verbindung, die in saurem Medium an mindestens einer Stelle des Moleküls mit Formaldehyd zu kondensieren vermag, und
X das Anion des Diazoniumsalzes ist,

mit inkohärentem aktinischem Licht hinter einer Vorlage belichtet und die unbelichteten Bereiche der lichtempfindlichen Schicht mit einem Entwickler auswäscht, dadurch gekennzeichnet, daß man ein Aufzeichnungsmaterial verwendet, dessen lichtempfindliche Schicht 6 bis 20 Gewichtsteile Aminharz je Gewichtsteil Polykondensationsprodukt enthält.

2. Verfahren nach Anspruch 1, dadurch gekennzeichnet, daß das Aufzeichnungsmaterial ein Diazoniumsalz-Polykondensationsprodukt enthält, in dem

B der Rest eines aromatischen Amins, eines Phenols, Thiophenols, Phenoläthers, aromatischen Thioäthers, aromatischen Kohlenwasserstoffs, einer aromatischen heterocyclischen Verbindung oder eines organischen Säureamids ist.

3. Verfahren nach Anspruch 1, dadurch gekennzeichnet, daß das Aufzeichnungsmaterial ein Diazoniumsalz-Polykondensationsprodukt enthält, in dem A der Rest einer Verbindung der Formel

$$(R_1—R_3—)_pR_2—N_2X$$

ist, worin

X das Anion des Diazoniumsalzes,
p eine ganze Zahl von 1 bis 3,
$R_1$ einen aromatischen Rest mit mindestens einer kondensationsfähigen Position,
$R_2$ eine unsubstituierte oder durch Halogenatome, Carboxyl-, Sulfonyl-, Alkyl- oder Alkoxy- gruppen substituierte Phenylgruppe,
$R_3$ eine Einfachbindung oder eine der Gruppen:

$$—(CH_2)_q—NR_4—$$

$$—O—(CH_2)_r—NR_4—$$

$$—S—(CH_2)_r—NR_4—$$

$$—S—CH_2CO—NR_4—$$

$$—O—R_5—O—$$

$$—O—$$

$$—S— \text{ oder}$$

$$—CO—NR_4—$$

bedeutet, worin

q eine Zahl von 0 bis 5,
r eine Zahl von 2 bis 5,
$R_4$ Wasserstoff, eine Alkylgruppe mit 1—5 C-Atomen, eine Aralkylgruppe mit 7—12 C-Atomen oder eine Arylgruppe mit 6—12 C-Atomen, und
$R_5$ eine Arylengruppe mit 6—12 C-Atomen ist.

4. Verfahren nach Anspruch 1, dadurch gekennzeichnet, daß das Aufzeichnungsmaterial 7 bis 15 Gewichtsteile Aminharz je 1 Gewichtsteil Diazoniumsalz-Polykondensationsprodukt enthält.

5. Verfahren nach Anspruch 1, dadurch gekennzeichnet, daß das Aminharz ein Amin-Formaldehyd-Kondensationsharz ist.

6. Verfahren nach Anspruch 5, dadurch gekennzeichnet, daß das Aminharz ein Kondensationsprodukt aus Formaldehyd und Harnstoff, einem Urethan, Anilin oder Melamin ist.

7. Verfahren nach Anspruch 1, dadurch gekennzeichnet, daß das Aufzeichnungsmaterial zusätzlich einen Farbstoff enthält.

8. Verfahren nach Anspruch 7, dadurch gekennzeichnet, daß der Farbstoff ein Triphenylmethanfarbstoff ist.

**Revendications**

1. Procédé d'obtention d'enregistrements en relief, dans lequel un matériel d'enregistrement, contenant dans sa couche photosensible une résine aminée et un produit de polycondensation d'un sel de diazonium constitué par des unités récurrentes des types généraux:

$$[A—N_2X] \text{ et } [B]$$

qui sont liés entre eux par des éléments intermédiaires à deux liaisons ouvertes, dérivés d'un composé carbonylé susceptible d'engager une condensation, dans lesquels

A est le reste d'un sel de diazonium, renfermant au moins deux noyaux aromatiques isocycliques ou hétérocycliques et qui est susceptible d'engager en milieu acide à au moins une position de la molécule und condensation avec le formaldéhyde,
B est le reste d'un composé exempt de groupes diazonium susceptible d'engager en milieu acide à au moins une position de la molécule une condensation avec le formaldéhyde, et
X est l'anion dusel de diazonium,

est exposé sous un original à une lumière actinique incohérente, après quoi les zones non exposées de la couche photosensible sont lavées avec un révélateur, caractérisé en ce qu'on utilise un matériel d'enregistrement dont la couche photosensible contient entre 6 et 20 parties en poids de résine aminée par partie en poids de produit de polycondensation.

2. Procédé selon la revendication 1, caractérisé en ce que le matériel d'enregistrement contient un produit de polycondensation d'un sel de diazonium dans lequel

B est le reste d'une amine aromatique, d'un phénol, d'un thiophénol, d'un éther phénolique, d'un thioéther aromatique, d'un hydrocarbure aromatique, d'un composé hétérocyclique aromatique ou d'un amide d'un acide organique.

3. Procédé selon la revendication 1, caractérisé en ce que le matériel d'enregistrement contient un produit de polycondensation d'un sel de diazonium dans lequel A est reste d'un composé de formule

$$(R_1—R_3—)_pR_2—N_2X$$

dans laquelle

X est l'anion du sel de diazonium,
p est un nombre entier entre 1 et 3,
$R_1$ est un reste aromatique ayant au moins une position susceptible d'engager une condensation,
$R_2$ est un groupe phényle non substitué ou substitué par des atomes d'halogène, carboxyle, sulfonyle, alkyle ou alcoxy,
$R_3$ est une liaison simple ou un des groupes suivants:

$$—(CH_2)_q—NR_4—$$

$$—O—(CH_2)_r—NR_4—$$

$$—S—(CH_2)_r—NR_4—$$

$$—S—CH_2CO—NR_4—$$

$$—O—R_5—O—$$

$$—O—$$

—S—

—CO—$NR_4$—

dans lesquels

q est un nombre compris entre 0 et 5
r est un nombre entre 2 et 5
$R_4$ est un atome d'hydrogène, un groupe alkyle ayant de 1 à 5 atomes de C, un groupe aralkyle ayant de 7 à 12 atomes de C, ou un groupe aryle ayant de 6 à 12 atomes de C, et
$R_5$ est un groupe arylène ayant de 6 à 12 atomes de C.

4. Procédé selon la revendication 1, caractérisé en ce que le matériel d'enregistrement contient entre 7 et 15 parties en poids de résine aminée par partie en poids de produit de polycondensation d'un sel de diazonium.

5. Procédé selon la revendication 1, caractérisé en ce que la résine aminée est une résine formée par condensation d'une amine et de formaldéhyde.

6. Procédé selon la revendication 5, caractérisé en ce que la résine aminée est un produit de condensation à partir de formaldéhyde et d'urée, d'un uréthane, d'aniline ou de mélamine.

7. Procédé selon la revendication 1, caractérisé en ce que le matériel d'enregistrement contient en outre un colorant.

8. Procédé selon la revendication 7, caractérisé en ce que le colorant est un colorant dérivé du triphénylméthane.

## Claims

1. A process for the preparation of relief-type recordings, wherein a light-sensitive recording material comprising in its light-sensitive layer an amine resin and a diazonium salt polycondensation product consisting of recurrent units of the general types

$$[A—N_2X] \text{ and } [B]$$

which are connected with each other by bivalent intermediate members derived from a condensable carbonyl compound and wherein

A is the radical of a diazonium salt which comprises at least two isocyclic or heterocyclic aromatic rings and which in at least one position of its molecule is capable of condensation with formaldehyde in an acid medium,
B is the radical of a compound free of diazonium groups which in at least one position of its molecule is capable of condensation with formaldehyde in an acid medium, and
X is the anion of the diazonium salt,

which is exposed under a master with incoherent actinic light and the unexposed areas of the light-sensitive layer are then removed by washing with a developer, characterized in that the light-sensitive layer of the recording material contains from 6 to 20 parts by weight of amine resin per part by weight of the polycondensation product.

2. A process according to claim 1, characterized in that the recording material contains a diazonium salt polycondensation product in which

B is the radical of an aromatic amine, of a phenol, a thiophenol, a phenol ether, an aromatic thioether, an aromatic hydrocarbon, an aromatic heterocyclic compound, or an organic acid amide.

3. A process according to claim 1, characterized in that the recording material contains a diazonium salt polycondensation product in which A is the radical of a compound corresponding to the following formula

$$(R_1—R_3—)_pR_2—N_2X$$

wherein

X is the anion of the diazonium salt,
p is a whole number from 1 to 3,
$R_1$ is an aromatic group with at least one condensable position,
$R_2$ is a phenylene group which may be unsubstituted or substituted by halogen atoms, carboxyl groups, sulfonyl groups, alkyl groups or alkoxy groups,
$R_3$ is a single bond or one of the following groups

$$—(CH_2)_q—NR_4—$$

$$—O—(CH_2)_r—NR_r—$$

$$—S—(CH_2)_r—NR_4—$$

$$—S—CH_2CO—NR_4—$$

$$—O—R_5—O—$$

$$—O—$$

$$—S—$$ or

$$—CO—NR_4—$$

wherein

q is a whole number from 0 to 5,
r is a whole number from 2 to 5,
$R_4$ is hydrogen, or an alkyl group with 1 to 5 carbon atoms, an aralkyl group with 7 to 12 carbon atoms, or an aryl group with 6 to 12 carbon atoms, and
$R_5$ is an arylene group with 6 to 12 carbon atoms.

4. A process according to claim 1, characterized in that the recording material contains from 7 to 15 parts by weight of the amine resin per part by weight of the diazonium salt polycondensate.

5. A process according to claim 1, characterized in that the amine resin is an amine/formaldehyde condensation resin.

6. A process according to claim 5, characterized in that the amine resin is a condensation product of formaldehyde with urea, a urethane, aniline, or melamine.

7. A process according to claim 1, characterized in that the resulting material additionally contains a dye.

8. A process according to claim 7, characterized in that the dye used is a triphenyl methane dye.